# EUROPÄISCHE PATENTSCHRIFT

(11) **EP 2 436 050 B1**
(45) Veröffentlichungstag und Bekanntmachung des Hinweises auf die Patenterteilung: **06.01.2016**
(21) Anmeldenummer: 10720162.6
(22) Anmeldetag: 21.05.2010
(51) Int. Cl.: H01L 41/083, H01L 41/273

(54) **PIEZOELEKTRISCHES VIELSCHICHTBAUELEMENT**
PIEZOELECTRIC MULTILAYER COMPONENT
COMPOSANT PIÉZOÉLECTRIQUE À COUCHES MULTIPLES

(30) Priorität: 29.05.2009 DE 102009023349; 25.09.2009 DE 102009043000
(43) Veröffentlichungstag der Anmeldung: 04.04.2012
(73) Patentinhaber: Epcos AG, 81669 München (DE)
(72) Erfinder: DERNOVSEK, Oliver, A-8501 Lieboch (AT); GLAZUNOV, Alexander, A-8530 Deutschlandsberg (AT)
(74) Vertreter: Epping - Hermann - Fischer
(86) Internationale Anmeldenummer: PCT/EP2010/057078
(87) Internationale Veröffentlichungsnummer: WO 2010/139568

(56) Entgegenhaltungen:
- EP-A1- 2 226 863
- DE-A1-102004 031 404
- DE-A1-102005 015 112
- DE-A1-102007 008 120

## Beschreibung

Es wird ein piezoelektrisches Vielschichtbauelement mit einem Stapel aus gesinterten piezoelektrischen Schichten und dazwischen angeordneten Innenelektroden angegeben. Ein derartiges Vielschichtbauelement ist beispielsweise ein Piezoaktor, der zum Betätigen eines Einspritzventils in einem Kraftfahrzeug eingesetzt werden kann.

In der Druckschrift DE 10307825 A1 wird ein Vielschichtbauelement beschrieben, das eine keramische Sollbruchschicht aufweist.

In der Druckschrift DE 10234787 C1 wird ein Vielschichtaktor beschrieben, bei dem Mikrostörungen im Aktorgefüge eingefügt sind.

In der Druckschrift DE 102005015112 A1 wird ein piezoelektrisches Bauteil beschrieben, bei dem eine Entkopplungsschicht zwischen einer Piezokeramikschicht und einer Elektrodenschicht angeordnet ist.

In der Druckschrift DE 102004031404 A1 wird ein piezoelektrisches Bauteil beschrieben, bei dem eine Sollbruchstelle von einer Elektrodenschicht oder einer Keramikschicht gebildet wird.

In der Druckschrift EP 2226863 A1 wird ein piezoelektrisches Vielschichtbauelement beschrieben, das eine Schwächungsschicht aufweist, bei der keramische Anteile durch Hohlräume voneinander getrennt sind.

Es ist eine zu lösende Aufgabe, ein piezoelektrisches Vielschichtbauelement anzugeben, das eine erhöhte Zuverlässigkeit aufweist.

Es wird ein piezoelektrisches Vielschichtbauelement angegeben, das einen Stapel aus gesinterten piezoelektrischen Schichten und dazwischen angeordneten Innenelektroden aufweist.

Vorzugsweise weist das Vielschichtbauelement einen monolithischen Grundkörper auf, der beispielsweise aus dünnen Folien eines piezoelektrischen Materials wie Blei-Zirkonat-Titanat (PZT) hergestellt wird. Die Innenelektroden können in Form von Elektrodenschichten ausgebildet sein und mittels eines Siebdruckverfahrens als Metallpaste auf die Folien aufgebracht werden. Die Folien werden anschließend gestapelt, verpresst und gemeinsam gesintert. Dabei muss nicht auf jede Folie eine Elektrodenschicht aufgebracht werden. Beispielsweise können einige piezoelektrische Folien übereinander angeordnet sein, zwischen denen sich keine Elektrodenschichten befinden.

Als "piezoelektrische Schicht" wird ein Abschnitt des Stapels bezeichnet, der ein piezoelektrisches Material aufweist und in Stapelrichtung von zwei benachbarten Innenelektroden begrenzt wird. Eine piezoelektrische Schicht ist aus einer oder mehreren piezoelektrischen Lagen gebildet, die entlang der Stapelrichtung übereinander angeordnet sind. Beispielsweise kann eine piezoelektrische Lage aus einer piezoelektrischen Grünfolie hervorgehen. Eine piezoelektrische Schicht kann auch nur eine einzige piezoelektrische Lage aufweisen.

Vorzugsweise sind auf zwei gegenüberliegenden Außenflächen des Bauelements Außenelektroden aufgebracht. Eine Außenelektrode umfasst beispielsweise eine auf dem Stapel eingebrannte Grundmetallisierung. Die Innenelektroden sind vorzugsweise entlang der Stapelrichtung des Bauelements abwechselnd mit den Außenelektroden verbunden. Dazu sind die Innenelektroden beispielsweise abwechselnd bis zu einer der Außenelektroden geführt und weisen zur zweiten Außenelektrode einen Abstand auf. Auf diese Weise sind die Innenelektroden einer Polarität über eine gemeinsame Außenelektrode elektrisch miteinander verbunden.

Nach dem Sintern und dem Aufbringen von Außenelektroden werden die piezoelektrischen Schichten polarisiert. Dazu wird beispielsweise zwischen benachbarten Innenelektroden eine Gleichspannung angelegt und der Stapel erwärmt. In so genannten inaktiven Zonen, in denen sich benachbarte Innenelektroden unterschiedlicher Polarität in Stapelrichtung nicht überlappen, dehnt sich das piezoelektrische Material gar nicht oder weniger aus als in den aktiven Zonen, in denen eine Überlappung auftritt. Durch die unterschiedliche Ausdehnung der piezoelektrischen Schichten in inaktiven und aktiven Zonen entstehen mechanische Spannungen, die während der Polarisation, bei thermischen Prozessen oder im Betrieb des Piezoaktors zu Rissen führen können. Verlaufen diese Risse parallel zur Stapelrichtung, besteht die Gefahr, dass benachbarte Innenelektroden unterschiedlicher Polarität durch die Risse verbunden werden und es zum Kurzschluss des Bauelements kommt.

Zumindest eine der piezoelektrischen Lagen ist als Schwächungslage ausgebildet. Die Schwächungslage weist eine geringere Rissfestigkeit auf als wenigstens eine andere piezoelektrische Lage.

Vorzugsweise ist die Rissfestigkeit derart reduziert, dass beim Auftreten von Spannungen im Bauelement Risse mit hoher Wahrscheinlichkeit im Bereich der Schwächungslage entstehen und sich nur entlang der Schwächungslage ausbreiten. Auf diese Weise soll verhindert werden, dass die Risse benachbarte Innenelektroden unterschiedlicher Polarität elektrisch verbinden und zum Kurzschluss führen.

Vorzugsweise ist die Haftfestigkeit der Schwächungslage zu einer angrenzenden piezoelektrischen Lage geringer als die Haftfestigkeit einer anderen piezoelektrischen Lage zu einer an diese angrenzenden piezoelektrischen Lage.

In diesem Fall entstehen Risse mit hoher Wahrscheinlichkeit zwischen der Schwächungslage und der angrenzenden piezoelektrischen Lage und breiten sich nur innerhalb dieses Bereiches aus.

Weiterhin wird ein Piezoaktor in Vielschichtbauweise angegeben, der einen Stapel aus gesinterten piezoelektrischen Schichten und dazwischen angeordneten Elektrodenschichten aufweist. Der Stapel enthält zumindest eine piezoelektrische Schwächungslage, die eine Haftfestigkeit zu angrenzenden piezoelektrischen Schichten aufweist, die gegenüber der Haftfestigkeit zwischen weiteren piezoelektrischen Schichten vermindert ist. Die verminderte Haftfestigkeit ist durch eine geringere Reaktivität der piezoelektrischen Schicht beim Sintervorgang erzeugt.

Erfindungsgemäß ist die Dicke der Schwächungslage wesentlich geringer als die Dicke wenigstens einer anderen piezoelektrischen Lage.

Beispielsweise ist die Schwächungslage nur halb so dick wie eine andere piezoelektrische Lage. Vorzugsweise ist die Schwächungslage dünner als eine andere piezoelektrische Lage, die sich in der gleichen piezoelektrischen Schicht wie die Schwächungslage befindet.

Beispielsweise liegt die Dicke der Schwächungslage im Bereich der Dicke einer Innenelektrode. In diesem Fall wird die Schwächungslage beispielsweise in einem Siebdruckverfahren auf eine piezoelektrische Grünfolie aufgebracht.

In einer Ausführungsform ist die Dicke der Schwächungslage größer als die Dicke einer Innenelektrode. Beispielsweise ist die Schwächungslage wenigstens doppelt so dick wie eine Innenelektrode. Vorzugsweise ist die Schwächungslage wesentlich dünner als eine andere piezoelektrische Lage und dicker als eine Innenelektrode, beispielsweise wenigstens doppelt so dick wie eine Innenelektrode. Beispielsweise kann eine Schwächungslage, die dicker ist als eine Innenelektrode, in Form einer Grünfolie hergestellt werden.

Durch die geringe Dicke der Schwächungslage wird die Ausdehnung eines Riss auf einen in Stapelrichtung eng begrenzten Bereich begrenzt. Auf diese Weise wird eine möglichst geringe Beeinträchtigung des Bauelements durch einen Riss erreicht. Zudem wird durch die geringe Ausdehnung der Schwächungslage in Stapelrichtung auch eine mögliche Beeinträchtigung der Funktion des Bauelements durch das Vorhandensein der Schwächungslage gering gehalten.

Beispielsweise resultiert die geringere Haftfestigkeit der Schwächungslage aus einer geringeren Sinteraktivität des Materials der Schwächungslage.

Vorzugsweise werden einige piezoelektrische Lagen aus einem ersten Material und die Schwächungslage aus einem zweiten Material hergestellt, wobei die Sinteraktivität des zweiten Materials geringer ist als die Sinteraktivität des ersten Materials. Insbesondere kann das zweite Material während des Sintervorgangs eine gegenüber dem ersten Material verminderte Diffusionsrate aufweisen.

In diesem Fall wächst das zweite Material der Schwächungslage weniger gut mit dem Material einer angrenzenden Lage zusammen als das erste Material einer piezoelektrischen Lage mit dem ersten Material einer an diese angrenzenden piezoelektrischen Lage. Dies führt im gesinterten Vielschichtbauelement zu einer verminderten Haftfestigkeit der Schwächungslage zur benachbarten piezoelektrischen Lage und damit zu einer Sollbruchstelle im Bereich der Schwächungslage.

Für die Anordnung der Schwächungslage im Stapel gibt es verschiedene Möglichkeiten. In einer Ausführungsform ist die Schwächungslage zwischen einer piezoelektrischen Lage und einer Innenelektrode angeordnet und grenzt an die piezoelektrische Lage und die Innenelektrode an.

In einer weiteren Ausführungsform ist die Schwächungslage innerhalb einer piezoelektrischen Schicht angeordnet. Vorzugsweise ist die Schwächungslage in diesem Fall zwischen zwei piezoelektrischen Lagen der piezoelektrischen Schicht angeordnet und grenzt an diese Lagen an. Diese Anordnung hat den Vorteil, dass ein Riss nicht entlang einer Elektrodenschicht erzeugt wird.

Vorzugsweise weist das Bauelement mehrere Schwächungslagen auf. Die Schwächungslagen können über den Stapel verteilt angeordnet sein. Beispielsweise kann an jede gewöhnliche, d. h., nicht in ihrer Haftfestigkeit verminderte piezoelektrische Lage, eine Schwächungslage angrenzen. In einer anderen Ausführungsform grenzen nur an einige gewöhnliche piezoelektrische Lagen Schwächungslagen an. Vorzugsweise sind die Schwächungslagen äquidistant angeordnet.

In einer Ausführungsform ist die Schwächungslage in einer Ebene senkrecht zur Stapelrichtung des Stapels strukturiert ausgebildet. Vorzugsweise weist die Schwächungslage Aussparungen auf.

Beispielsweise sind die Aussparungen in der Schwächungslage auf die aktive Zone des Stapels begrenzt, so dass die Schwächungslage in den inaktiven Zonen durchgehend ausgebildet ist. In diesem Fall ist die Schwächungslage in den inaktiven Zonen für eine möglichst optimale Rissbildung und Risssteuerung ausgelegt. Vorzugsweise reicht das Material der Schwächungslage wenigstens teilweise von der inaktiven Zone in die aktive Zone hinein. Vorzugsweise reicht das Material der an die Schwächungslage angrenzenden piezoelektrischen Lagen oder Innenelektroden in die Aussparungen in der aktiven Zone hinein, so dass innerhalb der Aussparungen die umgebenden piezoelektrischen Lagen oder eine angrenzende piezoelektrische Lage mit einer Innenelektrode fest zusammengesintert sind. Die Aussparungen sind vorzugsweise so angeordnet, dass sie die vollständige Ausbreitung eines Risses von einer Außenelektrode zur anderen Außenelektroden behindern. Auf diese Weise kann ein Kurzschluss zwischen den Außenelektroden verhindert werden.

Erfindungsgemäß enthalten die piezoelektrischen Lagen ein Keramikmaterial. Es wird zur Herstellung einiger piezoelektrischer Lagen ein erstes keramisches Material und zur Herstellung der Schwächungslage ein zweites keramisches Material verwendet. Vorzugsweise unterscheidet sich das erste keramische Material in seiner Zusammensetzung nur geringfügig oder gar nicht vom zweiten keramischen Material.

In einer Ausführungsform enthält das zweite keramische Material ein Keramikpulver, das bei einer höheren Temperatur kalziniert wird als das Keramikpulver im ersten keramischen Material. Auf diese Weise kann die Sinteraktivität des zweiten Materials reduziert werden.

In einer weiteren Ausführungsform enthält das zweite keramische Material ein Keramikpulver, bei dem weniger Blei enthalten ist als in dem Keramikpulver des ersten keramischen Materials. Beispielsweise enthält das zweite keramische Material einen geringeren Anteil an Bleioxid. Dies führt ebenfalls zur Verminderung der Sinteraktivität des zweiten Materials.

Die oben genannten Ausführungsformen für das Keramikpulver können auch kombiniert werden.
Weiterhin wird ein Verfahren zur Herstellung eines piezoelektrischen Vielschichtbauelements angegeben. Dabei werden piezoelektrische Grünfolien enthaltend ein erstes piezoelektrisches Material bereitgestellt. Zudem wird ein zweites piezoelektrisches Material bereitgestellt, das sich vom ersten piezoelektrischen Material in wenigstens einer der Eigenschaften Kalzinationstemperatur und Gehalt an Bleioxid vom Keramikmaterial unterscheidet. Es wird ein Stapel aus den piezoelektrischen Grünfolien und dem zweiten piezoelektrischen Material gebildet. Der Stapel weist wenigstens eine Lage enthaltend das zweite piezoelektrische Material auf. Die Dicke der Lage enthaltend das zweite piezoelektrische Material ist dabei so gewählt, dass die Lage im gesinterten Zustand wesentlich dünner ist als wenigstens eine andere, aus einer piezoelektrischen Grünfolie hergestellte, gesinterte piezoelektrische Lage. Anschließend wird der Stapel gesintert. Die Lage enthaltend das zweite piezoelektrische Material kann beispielsweise als eigene Grünfolie bereitgestellt werden. Beim Bilden des Stapels wird diese Grünfolie auf die Grünfolie enthaltend das erste piezoelektrische Material aufgebracht.

In einer alternativen Ausführungsform wird das zweite piezoelektrische Material mittels Siebdruck auf eine der Grünfolien enthaltend das erste piezoelektrische Material aufgebracht.

Im Folgenden werden das angegebene Bauelement und seine vorteilhaften Ausgestaltungen anhand von schematischen und nicht maßstabsgetreuen Figuren erläutert. Es zeigen:
- Figur 1A: einen Längsschnitt eines piezoelektrischen Vielschichtbauelements,
- Figur 1B: einen vergrößerten Ausschnitt aus Figur 1A,
- Figur 2A: einen Längsschnitt eines Teils eines piezoelektrischen Vielschichtbauelements, in dem ein Riss senkrecht zu den Innenelektroden verläuft,
- Figur 2B: einen Längsschnitt eines Teils eines piezoelektrischen Vielschichtbauelements, in dem ein Riss parallel zu den Innenelektroden verläuft,
- Figur 3: einen Längsschnitt eines Teils einer ersten Ausführungsform eines piezoelektrischen Vielschichtbauelements mit piezoelektrischen Schwächungslagen,
- Figur 4: einen Längsschnitt eines Teils einer zweiten Ausführungsform eines piezoelektrischen Vielschichtbauelements mit piezoelektrischen Schwächungslagen,
- Figur 5A: eine Aufsicht auf eine erste Ausführungsform einer piezoelektrischen Schwächungslage in einem piezoelektrischen Vielschichtbauelement,
- Figur 5B: eine Aufsicht auf eine zweite Ausführungsform einer piezoelektrischen Schwächungslage in einem piezoelektrischen Vielschichtbauelement,
- Figur 5C: eine Aufsicht auf eine dritte Ausführungsform einer piezoelektrischen Schwächungslage in einem piezoelektrischen Vielschichtbauelement,
- Figur 5D: eine Aufsicht auf eine vierte Ausführungsform einer piezoelektrischen Schwächungslage in einem piezoelektrischen Vielschichtbauelement.

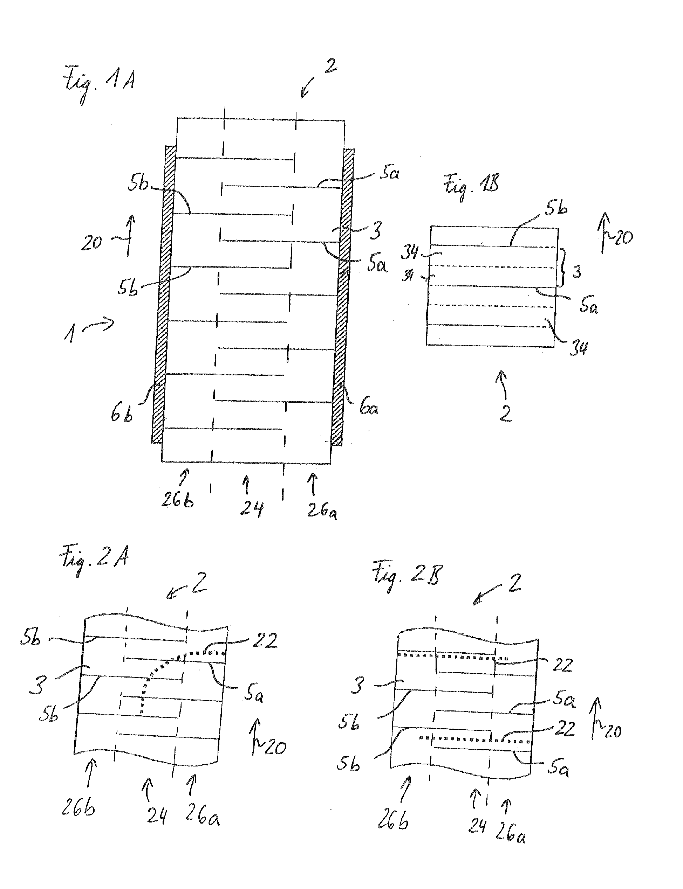

Figur 1 zeigt einen Längsschnitt eines piezoelektrischen Vielschichtbauelements 1 in Form eines Piezoaktors. Das Bauelement 1 weist einen Stapel 2 aus übereinander angeordneten piezoelektrischen Schichten 3 und dazwischen liegenden Innenelektroden 5a, 5b auf. Die Innenelektroden 5a, 5b sind als Elektrodenschichten ausgebildet. Die piezoelektrischen Schichten 3 und die Innenelektroden 5a, 5b sind entlang einer Stapelrichtung 20, die der Längsrichtung des Stapels 2 entspricht, übereinander angeordnet.

Die piezoelektrischen Schichten 3 enthalten ein keramisches Material, zum Beispiel Blei-Zirkonat-Titanat (PZT) oder eine bleifreie Keramik. Das Keramikmaterial kann auch Dotierstoffe enthalten. Die Innenelektroden 5a, 5b enthalten beispielsweise Silber-Palladium oder Kupfer. Insbesondere können die Innenelektroden 5a, 5b Materialien aus der Menge reines Kupfer, eine Mischung oder Legierung aus Kupfer und Palladium, reines Silber, eine Mischung oder Legierung aus Silber und Palladium, reines Platin oder eine Mischung aus Platin und Silber enthalten oder aus einem dieser Materialien bestehen.
Zur Herstellung des Stapels 2 werden beispielsweise Grünfolien, die ein Keramikpulver, ein organisches Bindemittel und ein Lösungsmittel enthalten, durch Folienziehen oder Foliengießen hergestellt. Auf einige der Grünfolien wird zur Bildung der Innenelektroden 5a, 5b eine Elektrodenpaste mittels Siebdruck aufgebracht. Die Grünfolien werden entlang einer Längsrichtung 20 übereinander gestapelt und verpresst. Aus dem Folienstapel werden die Vorprodukte der Bauelemente in der gewünschten Form herausgetrennt. Schließlich wird der Stapel aus piezoelektrischen Grünfolien und Elektrodenschichten gesintert.

Figur 1B zeigt einen Ausschnitt aus dem Stapel 2 aus piezoelektrischen Schichten 3 und Innenelektroden 5a, 5b gemäß Figur 1A.

Eine piezoelektrische Schicht 3 bezeichnet dabei den Bereich des Stapels der ein piezoelektrisches Material enthält und in Längsrichtung von zwei benachbarten Innenelektroden 5a, 5b begrenzt wird. Eine piezoelektrische Schicht 3 kann mehrere piezoelektrische Lagen 34 aufweisen. Beispielsweise ist eine piezoelektrische Lage 34 aus einer Grünfolie hergestellt.

In dem hier gezeigten Ausführungsbeispiel weist eine piezoelektrische Schicht 3 jeweils zwei piezoelektrische Lagen 34 auf. In weiteren Ausführungsformen kann eine piezoelektrische Schicht 3 auch nur eine piezoelektrische Lage 34 oder mehr als zwei piezoelektrische Lagen 34 aufweisen. Innerhalb eines Stapels 2 können sich die piezoelektrischen Schichten 3 auch in der Anzahl ihrer piezoelektrischen Lagen 34 unterscheiden.

Wie in Figur 1A zu sehen ist, weist das Bauelement 1 zwei Außenelektroden 6a, 6b auf, die an der Außenseite des Stapels 2 angeordnet sind. In der hier gezeigten Ausführungsform sind die Außenelektroden 6a, 6b auf gegenüberliegenden Seitenflächen des Bauelements 1 angeordnet und verlaufen streifenförmig entlang der Stapelrichtung 20. Die Außenelektroden 6a, 6b enthalten beispielsweise Silber-Palladium oder Kupfer und können als Metallpaste auf den Stapel 2 aufgebracht und eingebrannt werden.

Die Innenelektroden 5a, 5b sind entlang der Stapelrichtung 20 abwechselnd bis zu einer der Außenelektroden 6a, 6b geführt und von der zweiten Außenelektrode 6b, 6a beabstandet. Auf diese Weise sind die Außenelektroden 6a, 6b entlang der Stapelrichtung 20 abwechselnd mit den Innenelektroden 5a, 5b elektrisch verbunden. Zur Herstellung des elektrischen Anschlusses kann auf die Außenelektroden 6a, 6b ein Anschlusselement (hier nicht gezeigt), z. B. durch Löten, aufgebracht werden.

Das Bauelement 1 dehnt sich beim Anlegen einer Spannung zwischen die Außenelektroden 6a, 6b in Längsrichtung 20 aus. In einer so genannten aktiven Zone 24, in dem sich in Stapelrichtung 20 benachbarte Innenelektroden 5a, 5b überlappen, entsteht beim Anlegen einer Spannung an die Außenelektroden 6a, 6b ein elektrisches Feld, sodass sich die piezoelektrischen Schichten 3 in Längsrichtung 20 ausdehnen. In inaktiven Zonen 26a, 26b, in denen sich benachbarte Elektrodenschichten 5a, 5b nicht überlappen, dehnt sich der Piezoaktor nur geringfügig aus.

Aufgrund der unterschiedlichen Ausdehnung des Bauelements 1 in den aktiven 24 und inaktiven Zonen 26a, 26b treten mechanische Spannungen im Stapel 2 auf. Derartige Spannungen können zu Rissen im Stapel 2 führen.

Figur 2A zeigt einen Ausschnitt aus einem Stapel 2 aus piezoelektrischen Schichten 3 und Innenelektroden 5a, 5b, bei dem ein Riss 22 im Stapel 2 entstanden ist. Der Riss 22 verläuft innerhalb der inaktiven Zone 26a parallel zu den Innenelektroden 5a, 5b, knickt beim Übergang in die aktive Zone 24 ab und verläuft in der aktiven Zone 24 durch benachbarte Innenelektroden 5a, 5b unterschiedlicher Polarität hindurch. Dies kann zu einem Kurzschluss der Innenelektroden 5a, 5b führen.

Figur 2B zeigt einen Ausschnitt aus einem Stapel 2 aus piezoelektrischen Schichten 3 und Innenelektroden 5a, 5b, in dem ebenfalls ein Riss 22 entstanden ist. Hier verläuft der Riss 22 sowohl in den inaktiven Zonen 26a, 26b als auch in der aktiven Zone 24 parallel zu den Innenelektroden 5a, 5b. Bei einem derartigen Verlauf von Rissen 22 ist die Gefahr von Kurzschlüssen verringert.

Um einen derartigen Verlauf von Rissen 22 zu begünstigen, werden in den Stapel 2 piezoelektrische Schwächungslagen eingebracht, die eine verminderte Haftfestigkeit zu angrenzenden piezoelektrischen Lagen aufweisen. Durch die verminderte Haftfestigkeit entstehen Risse 22 besonders leicht an einer Grenzfläche zwischen der Schwächungslage und einer angrenzenden piezoelektrischen Lage und breiten sich besonders leicht entlang der Grenzfläche aus.

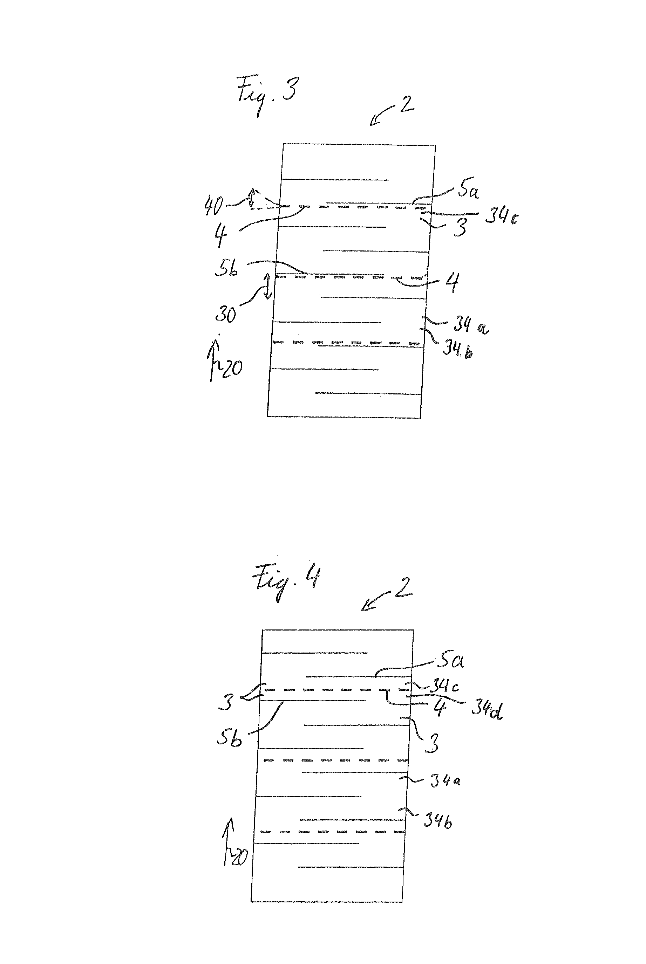

Figur 3 zeigt einen Längsschnitt eines Stapels 2 aus piezoelektrischen Schichten 3 und Innenelektroden 5a, 5b, bei dem piezoelektrischen Schwächungslagen 4 an mehreren Stellen des Stapels 2 angeordnet sind. Der Stapel 2 ist beispielsweise Teil eines Piezoaktors.

Die piezoelektrischen Schwächungslagen 4 weisen eine verminderte Haftfestigkeit zu einer angrenzenden piezoelektrischen Lage 34c einer piezoelektrischen Schicht 3 auf. Insbesondere ist die Haftfestigkeit einer Schwächungslage 4 geringer als die Haftfestigkeit einer anderen piezoelektrischen Lage 34a zu einer an diese angrenzenden piezoelektrischen Lage 34b. Die piezoelektrischen Schwächungslagen 4 sind hier jeweils zwischen einer piezoelektrischen Lage 34c und einer Innenelektrode 5a, 5b angeordnet und grenzen an die Innenelektrode 5a, 5b und an die piezoelektrische Lage 34c an. Die piezoelektrischen Schwächungslagen 4 können entlang der Längsrichtung 20 gesehen oberhalb oder unterhalb der angrenzenden Innenelektrode 5a, 5b angeordnet sein.

Die Dicken 40 der piezoelektrischen Schwächungslagen 4 sind wesentlich geringer als die Dicken 30 der anderen piezoelektrischen Lagen 34a, 34b, 34c. Beispielsweise sind die piezoelektrischen Schwächungslagen 4 zwischen 1 und 10 µm dick. Schwächungslagen mit derartigen Dicken können beispielsweise mittels Siebdruck hergestellt werden. In weiteren Ausführungsformen liegt die Dicke einer piezoelektrischen Schwächungslage zwischen 1 und 100 µm. Schwächungslagen im Bereich von 10 bis 100 µm können beispielsweise durch Folienziehen hergestellt werden.

Durch das Ausbilden von Schwächungslagen 4 soll erreicht werden, dass ein Riss möglichst in einer Ebene parallel zur Stapelrichtung 20 verläuft. Zudem soll durch die geringe Dicke 40 erreicht werden, dass das piezoelektrische Bauelement 1 möglichst wenig in seiner Funktion beeinträchtigt wird.

Zur Herstellung eines derartigen Stapels 2 mit Schwächungslagen 4 werden beispielsweise Grünfolien enthaltend ein erstes piezoelektrisches Material bereitgestellt. Auf einige der Grünfolien wird eine Elektrodenpaste mittels Siebdruck aufgebracht. Darauf wird ein zweites piezoelektrisches Material mittels Siebdruck aufgebracht, das gegenüber dem ersten piezoelektrischen Material eine verminderte Sinteraktivität aufweist. Das zweite piezoelektrische Material kann auch auf eine Grünfolie aufgebracht werden, bevor die Elektrodenpaste aufgebracht wird. Danach werden die Grünfolien übereinander gestapelt, verpresst und das grüne Vorprodukt des Bauelements herausgetrennt.

Alternativ dazu kann die piezoelektrische Schwächungslage 4 aus einer piezoelektrische Grünfolie enthaltend das zweite piezoelektrische Material hergestellt sein, die dann mit den anderen Grünfolien zu einem Stapel angeordnet und verpresst wird.

Der Stapel wird schließlich zu einem monolithischen Sinterkörper, beispielsweise bei einer Sintertemperatur im Bereich zwischen 800 und 1500° C, gesintert. Während des Sintervorgangs führen Diffusionsprozesse von Teilchen in den piezoelektrischen Lagen und in den Innenelektroden zu einer starken Anbindung zwischen den piezoelektrischen Lagen und den Innenelektroden. Insbesondere bilden die Metallteilchen aus den Elektrodenschichten einen festen Kontakt mit Körnern aus einer Keramikschicht.

Ebenso entsteht beim Sintern durch Diffusionsprozesse von Teilchen in den piezoelektrischen Lagen auch ein fester mechanischer Verbund zwischen einzelnen Lagen einer piezoelektrischen Schicht. Die keramischen Teilchen der verschiedenen Lagen wachsen zusammen und bilden eine feste Bindung an der Grenzfläche zweier Lagen.

Das zweite piezoelektrische Material weist während des Sintervorgangs eine deutlich geringe Diffusionsrate auf als das erste piezoelektrische Material. Die verminderte Diffusionsrate führt dazu, dass die Keramikteilchen aus dem zweiten piezoelektrischen Material und dem ersten piezoelektrischen Material nur schwach zusammenwachsen. Mikroskopisch betrachtet wird der Kontakt zwischen diesen Teilchen vorzugsweise nur auf die Bildung von Hälsen reduziert. Insbesondere ist die Diffusionsrate des zweiten piezoelektrischen Materials bei hohen Temperaturen, d. h. die beim Sintervorgang vorliegenden Temperaturen im Bereich von 800 bis 1500 ° C, deutlich geringer als die Diffusionsrate des ersten piezoelektrischen Materials.

Vorzugsweise unterscheidet sich die Zusammensetzung des zweiten piezoelektrischen Materials nur geringfügig oder nicht von der Zusammensetzung des ersten piezoelektrischen Materials.

Beispielsweise liegt der Anteil von Keramikpulver im ersten piezoelektrischen Material im grünen Zustand zwischen 30 und 70 vol%, bevorzugt zwischen 45 und 60 vol%. Die restlichen Volumenanteile werden beispielsweise durch Bindemittel und Poren eingenommen.

Vorzugsweise liegt der Volumenanteil an organischem Binder im zweiten piezoelektrischen Material möglichst nah am Volumenanteil im ersten piezoelektrischen Material. Auf diese Weise kann das Auftreten von Problemen während des Entbinderungsprozesses vermieden werden.

In einer Ausführungsform enthält das zweite piezoelektrische Material ein Keramikpulver, das bei einer höheren Temperatur kalziniert wird als Keramikpulver im ersten piezoelektrischen Material. Der Unterschied in der Kalzinationstemperatur beträgt vorzugsweise mindestens 20° C, besonders bevorzugt mindestens 50° C. Vorzugsweise ist die Zusammensetzung des Keramikmaterials in der Schwächungslage identisch zur Zusammensetzung in den anderen piezoelektrischen Lagen.

In einer weiteren Ausführungsform enthält das zweite piezoelektrische Material ein Keramikpulver, bei dem weniger Blei, z. B. in Form von Bleioxid, enthalten ist als in dem Keramikpulver des ersten piezoelektrischen Materials. Vorzugsweise enthält in diesem Fall das Keramikpulver Blei-Zirkonat-Titanat (PZT). Vorzugsweise beträgt der Unterschied mindestens 0,5 mol-% Blei, besonders bevorzugt mindestens 1,5 mol-% Blei.

Wie in Figur 3 gezeigt ist, sind im Stapel 2 mehrere Schwächungslagen 4 angeordnet. In weiteren Ausführungsformen eines Bauelements 1 befindet sich im Stapel 2 nur eine einzige Schwächungslage 4. In einer weiteren Ausführungsform kann auch an jede Innenelektrode 5a, 5b eine Schwächungslage 4 angrenzen.

Figur 4 zeigt eine weitere Ausführungsform eines Stapels 2, bei dem piezoelektrische Schwächungslagen 4 innerhalb der piezoelektrischen Schichten 3 angeordnet sind. Die piezoelektrischen Schwächungslagen 4 grenzen an zwei Lagen 34c, 34d einer piezoelektrischen Schicht 3 an. Die Herstellung eines derartigen Stapels 2 verläuft analog zur Herstellung des Stapels 2 gemäß Figur 3, wobei hier das zweite piezoelektrische Material nicht angrenzend an eine Elektrodenschicht aufgebracht wird.

Im hier gezeigten Ausführungsbeispiel sind mehrere piezoelektrische Schwächungslagen 4 im Stapel 2 verteilt angeordnet. In weiteren Ausführungsbeispielen kann sich nur eine einzige piezoelektrische Schwächungslagen 4 im Stapel 2 befinden. Alternativ dazu können auch zwischen allen Lagen 34 einer piezoelektrischen Schicht 3 piezoelektrische Schwächungslagen 4 angeordnet sein.

In weiteren Ausführungsformen können die Anordnungen der piezoelektrischen Schwächungslagen 4 gemäß Figur 3 und Figur 4 auch kombiniert werden, sodass in einem Stapel 2 einige piezoelektrische Schwächungslagen 4 an Innenelektroden 5a, 5b angrenzen und weitere piezoelektrische Schwächungslagen 4 innerhalb piezoelektrischer Schichten 3 angeordnet sind.

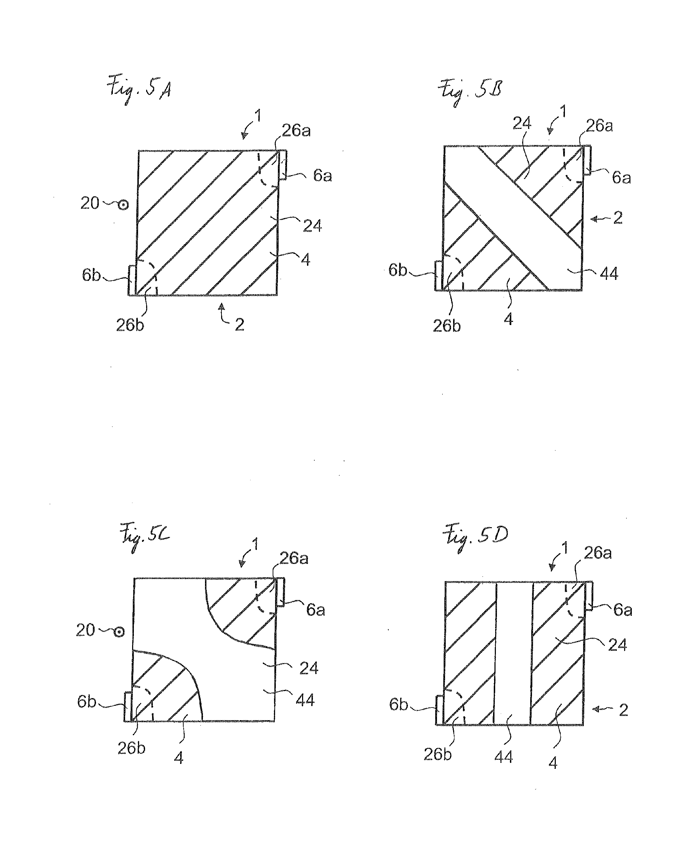

Die Figuren 5A bis 5D zeigen verschiedene Ausführungsformen für strukturierte piezoelektrische Schwächungslagen 4. Es ist jeweils ein Querschnitt eins Bauelements 1 mit einer Aufsicht auf eine piezoelektrische Schwächungslage 4 zu sehen.

Die Außenelektroden 6a, 6b sind auf gegenüberliegenden Seitenflächen des Stapels 2 angeordnet und verlaufen als schmale Streifen entlang der Längsrichtung 20 im Bereich diagonal gegenüberliegender Längskanten. Die Elektrodenschichten (hier nicht zu sehen) sind abwechselnd bis zu einer der Außenelektroden 6a, 6b geführt und von der weiteren Außenelektrode 6b, 6a beabstandet. Die inaktiven Zonen 26a, 26b verlaufen innerhalb eines eng begrenzten Bereichs im Bereich der diagonal gegenüberliegenden Längskanten.

Figur 5A zeigt eine Ausführungsform, in der die piezoelektrische Schwächungslage 4 den gesamten Querschnitt des Stapels 2 bedeckt.

Figur 5B zeigt eine Ausführungsform, bei der die piezoelektrische Schwächungslage 4 eine Aussparung 44 aufweist, die entlang einer Diagonalen des Stapels 2 verläuft.

In der Aussparung 44 ist erstes piezoelektrisches Material der darunter liegenden piezoelektrischen Schicht oder Material einer Innenelektrode 5a, 5b zu sehen. Vorzugsweise ist die piezoelektrische Schwächungslage 4 mittels Siebdruck auf eine andere piezoelektrische Lage aufgebracht.

Das Material der piezoelektrischen Schwächungslage 4 ist im Bereich der inaktiven Zonen 26a, 26b aufgebracht. Auf diese Weise ist in dem Bereich, in dem mechanische Spannungen und somit auch Risse verstärkt auftreten, die Schwächungslage hinsichtlich ihres Rissbildungs- und Rissführungsvermögens optimiert. Innerhalb der Aussparung, die in der aktiven Zone 24 liegt, ist hingegen eine erhöhte Haftfestigkeit vorhanden. Somit verlaufen Risse mit verminderter Wahrscheinlichkeit im Bereich der Aussparung 44 oder durch die Aussparung 44 hindurch. Die Aussparung 44 ist so angeordnet, dass ein Riss mit geringer Wahrscheinlichkeit in der Ebene der piezoelektrischen Schwächungslage 4 von einer Außenelektrode 6a zu der diagonal gegenüberliegenden Außenelektrode 6b verläuft. Auf diese Weise wird die Gefahr eines Kurzschlusses zwischen den Außenelektroden 6a, 6b vermindert.

Figur 5C zeigt eine weitere Ausführungsform einer piezoelektrischen Schwächungslage 4, bei der eine Aussparung 44 vorhanden ist. Auch hier ist die Aussparung 44 in der aktiven Zone 24 angeordnet und ist derart zwischen den inaktiven Zonen 26a, 26b angeordnet, dass ein Riss mit geringer Wahrscheinlichkeit die Außenelektroden 6a, 6b miteinander elektrisch leitend verbindet. Die Aussparung 44 weist abgerundete Außenlinien auf. Auf diese Weise kann die Wahrscheinlichkeit für das Abknicken eines Risses in die Aussparung 44 hinein verringert werden.

Figur 5D zeigt eine weitere Ausführungsform, bei der die piezoelektrische Schwächungslage 4 eine Aussparung 44 aufweist, die parallel zu den gegenüberliegenden Außenseiten des Bauelements 1 verläuft, auf dem die Außenelektroden 6a, 6b angeordnet sind, und die zwei weiteren Außenseiten des Stapels verbindet.

Die möglichen Ausführungsformen für piezoelektrische Schwächungslagen sind nicht auf die hier gezeigten Geometrien beschränkt. Insbesondere kann die Aussparung nicht nur parallel zu den Seitenflächen oder entlang einer Diagonale des Stapels verlaufen, sondern auch eine beliebige andere Orientierung aufweisen.

Die Erfindung ist nicht durch die Beschreibung an Hand der Ausführungsbeispiele auf diese beschränkt, sondern umfasst jedes neue Merkmal sowie jede Kombination von Merkmalen. Dies beinhaltet insbesondere jede Kombination von Merkmalen in den Patentansprüchen, auch wenn dieses Merkmal oder diese Kombination selbst nicht explizit in den Patentansprüchen oder Ausführungsbeispielen angegeben ist.

### Bezugszeichenliste

- 1: Bauelement
- 2: Stapel
20 Längsrichtung
22 Riss
24 aktive Zone
26a, 26b inaktive Zone
- 3: piezoelektrische Schicht
30 Dicke
34, 34a, 34b, 34c, 34d piezoelektrische Lage
- 4: Schwächungslage
40 Dicke
44 Aussparung
- 5a, 5b: Innenelektrode
- 6a, 6a: Außenelektrode

## Patentansprüche

1. Piezoelektrisches Vielschichtbauelement,
aufweisend einen Stapel (2) aus gesinterten piezoelektrischen Schichten (3) und dazwischen angeordneten Innenelektroden (5a, 5b), bei dem eine piezoelektrische Schicht (3) wenigstens eine piezoelektrische Lage (34) umfasst,
bei dem zumindest eine der piezoelektrischen Lagen (34) als Schwächungslage (4) ausgebildet ist, die eine geringere Rissfestigkeit als wenigstens eine andere piezoelektrische Lage (34) aufweist,
bei dem die Dicke (40) der Schwächungslage (4 ) wesentlich geringer ist als die Dicke (30) wenigstens einer anderen piezoelektrischen Lage (34),
wobei die piezoelektrischen Lagen (34) ein Keramikmaterial enthalten,
**dadurch gekennzeichnet, dass**
das Keramikmaterial der Schwächungslage (4) sich in wenigstens einer der Eigenschaften Kalzinationstemperatur und Gehalt an Bleioxid vom Keramikmaterial wenigstens einer anderen piezoelektrischen Lage (34) unterscheidet.

2. Vielschichtbauelement nach Anspruch 1,
bei dem die Schwächungslage (4) eine Haftfestigkeit zu einer angrenzenden piezoelektrischen Lage (34c, 34d) aufweist, die geringer ist als die Haftfestigkeit einer anderen piezoelektrischen Lage (34a) zu einer an dieser angrenzenden piezoelektrischen Lage (34b).

3. Vielschichtbauelement nach Anspruch 2,
bei dem die geringere Haftfestigkeit der Schwächungslage (4) aus einer geringeren Sinteraktivität des Materials der Schwächungslage (34) resultiert.

4. Vielschichtbauelement nach einem der Ansprüche 1 bis 3,
bei dem die Dicke der Schwächungslage (4) im Bereich von 1 bis 10 µm liegt.

5. Vielschichtbauelement nach einem der Ansprüche 1 bis 4,
bei dem die Schwächungslage (4) zwischen einer piezoelektrischen Lage (34c) und einer Innenelektrode (5a, 5b) angeordnet ist und an beide (34c, 5a, 5b) angrenzt.

6. Vielschichtbauelement nach einem der Ansprüche 1 bis 4,
bei dem die Schwächungslage (4) innerhalb einer piezoelektrischen Schicht (3) angeordnet ist.

7. Vielschichtbauelement nach Anspruch 6,
bei dem die Schwächungslage (4) zwischen zwei piezoelektrischen Lagen (34) der piezoelektrischen Schicht (3) angeordnet ist und and diese angrenzt.

8. Vielschichtbauelement nach einem der Ansprüche 1 bis 7,
bei dem mehrere Schwächungslagen (4) über den Stapel (2) verteilt angeordnet sind.

9. Vielschichtbauelement nach einem der Ansprüche 1 bis 8, bei dem die Schwächungslage (4) in einer Ebene senkrecht zur Stapelrichtung (20) des Stapels (2) strukturiert ist.

10. Vielschichtbauelement nach Anspruch 9,
bei dem die Schwächungslage (4) Aussparungen (44) aufweist.

11. Verfahren zur Herstellung eines piezoelektrischen Vielschichtbauelements umfassend die Schritte:
A) Bereitstellen von piezoelektrischen Grünfolien enthaltend ein erstes piezoelektrisches Material,
B) Bereitstellen eines zweiten piezoelektrischen Materials, das sich vom ersten piezoelektrischen Material in seiner Sinteraktivität unterscheidet, wobei das erste und das zweite piezoelektrische Material ein Keramikmaterial enthalten und wobei das Keramikmaterial des zweiten piezoelektrischen Materials sich in wenigstens einer der Eigenschaften Kalzinationstemperatur und Gehalt an Bleioxid vom Keramikmaterial des ersten piezoelektrischen Materials unterscheidet,
C) Bilden eines Stapels (2) aus den piezoelektrischen Grünfolien und wenigstens einer Lage enthaltend das zweite piezoelektrische Material, wobei die Dicke der Lage so gewählt ist, dass die Lage im gesinterten Zustand wesentlich dünner ist als wenigstens eine andere aus einer piezoelektrischen Grünfolie hergestellten gesinterten Lage,
D) Sintern des Stapels (2).

12. Verfahren nach Anspruch 11,
wobei in Schritt B) das zweite piezoelektrische Material als Grünfolie bereitgestellt wird und in Schritt C) diese Grünfolie auf die Grünfolie enthaltend das erste piezoelektrische Material aufgebracht wird.

13. Verfahren nach Anspruch 11,
wobei in Schritt C) das zweite piezoelektrische Material mittels Siebdruck auf eine der Grünfolien enthaltend das erste piezoelektrische Material aufgebracht wird.

## Claims

1. Piezoelectric multilayer component,
comprising a stack (2) of sintered piezoelectric layers (3) and internal electrodes (5a, 5b) arranged therebetween, wherein a piezoelectric layer (3) comprises at least one piezoelectric ply (34),
wherein at least one of the piezoelectric plies (34) is embodied as a weakening ply (4) having a lower crack resistance than at least one other piezoelectric ply (34),
wherein the thickness (40) of the weakening ply (4) is significantly less than the thickness (30) of at least one other piezoelectric ply (34),
wherein the piezoelectric plies (34) contain a ceramic material, **characterized in that** the ceramic material of the weakening ply (4) differs from the ceramic material of at least one other piezoelectric ply (34) in at least one of the properties: calcination temperature and content of lead oxide.

2. Multilayer component according to Claim 1,
wherein the weakening ply (4) has an adhesive strength with respect to an adjoining piezoelectric ply (34c, 34d) which is lower than the adhesive strength of another piezoelectric ply (34a) with respect to a piezoelectric ply (34b) adjoining the latter.

3. Multilayer component according to Claim 2,
wherein the lower adhesive strength of the weakening ply (4) results from a lower sintering activity of the material of the weakening ply (34).

4. Multilayer component according to any of Claims 1 to 3,
wherein the thickness of the weakening ply (4) is in the range of 1 to 10 µm.

5. Multilayer component according to any of Claims 1 to 4,
wherein the weakening ply (4) is arranged between a piezoelectric ply (34c) and an internal electrode (5a, 5b) and adjoins both (34c, 5a, 5b).

6. Multilayer component according to any of Claims 1 to 4,
wherein the weakening ply (4) is arranged within a piezoelectric layer (3).

7. Multilayer component according to Claim 6, wherein the weakening ply (4) is arranged between two piezoelectric plies (34) of the piezoelectric layer (3) and adjoins them.

8. Multilayer component according to any of Claims 1 to 7,
wherein a plurality of weakening plies (4) are arranged in a manner distributed over the stack (2).

9. Multilayer component according to any of Claims 1 to 8,
wherein the weakening ply (4) is structured in a plane perpendicular to the stacking direction (20) of the stack (2).

10. Multilayer component according to Claim 9,
wherein the weakening ply (4) has cutouts (44).

11. Method for producing a piezoelectric multilayer component, comprising the following steps:
A) providing piezoelectric green sheets containing a first piezoelectric material,
B) providing a second piezoelectric material, which differs from the first piezoelectric material in its sintering activity, wherein the first and the second piezoelectric material contain a ceramic material and wherein the ceramic material of the second piezoelectric material differs from the ceramic material of the first piezoelectric material in at least one of the properties: calcination temperature and content of lead oxide,
C) forming a stack (2) of the piezoelectric green sheets and at least one ply containing the second piezoelectric material, wherein the thickness of the ply is chosen such that the ply in the sintered state is significantly thinner than at least one other sintered ply produced from a piezoelectric green sheet,
D) sintering the stack (2).

12. Method according to Claim 11,
wherein, in step B), the second piezoelectric material is provided as a green sheet and, in step C), said green sheet is applied to the green sheet containing the first piezoelectric material.

13. Method according to Claim 11,
wherein, in step C), the second piezoelectric material is applied to one of the green sheets containing the first piezoelectric material by means of screen printing.

## Revendications

1. Composant multicouche piézoélectrique, comprenant une pile (2) de couches piézoélectriques frittées (3) et d'électrodes internes (5a, 5b) disposées entre elles, avec lequel une couche piézoélectrique (3) comprend au moins une strate piézoélectrique (34),
avec lequel au moins l'une des strates piézoélectriques (34) est réalisée sous la forme d'une strate d'affaiblissement (4), laquelle possède une résistance à la déchirure plus faible qu'au moins une autre strate piézoélectrique (34),
avec lequel l'épaisseur (40) de la strate d'affaiblissement (4) est sensiblement inférieure à l'épaisseur (30) d'au moins une autre strate piézoélectrique (34),
les strates piézoélectriques (34) contenant un matériau céramique,
**caractérisé en ce que**
le matériau céramique de la strate d'affaiblissement (4) se différencie du matériau céramique d'au moins une autre strate piézoélectrique (34) au moins par l'une des propriétés température de calcination et teneur en oxyde de plomb.

2. Composant multicouche selon la revendication 1, avec lequel la strate d'affaiblissement (4) possède une adhésivité à une strate piézoélectrique (34c, 34d) adjacente qui est inférieure à l'adhésivité d'une autre strate piézoélectrique (34a) à une strate piézoélectrique (34b) adjacente à celle-ci.

3. Composant multicouche selon la revendication 2, avec lequel l'adhésivité plus faible de la strate d'affaiblissement (4) résulte d'une activité de frittage plus faible du matériau de la strate d'affaiblissement (34).

4. Composant multicouche selon l'une des revendications 1 à 3, avec lequel l'épaisseur de la strate d'affaiblissement (4) se trouve dans la plage de 1 à 10 µm.

5. Composant multicouche selon l'une des revendications 1 à 4, avec lequel la strate d'affaiblissement (4) est disposée entre une strate piézoélectrique (34c) et une électrode interne (5a, 5b) et est adjacente aux deux (34c, 5a, 5b).

6. Composant multicouche selon l'une des revendications 1 à 4, avec lequel la strate d'affaiblissement (4) est disposée à l'intérieur d'une couche piézoélectrique (3).

7. Composant multicouche selon la revendication 6, avec lequel la strate d'affaiblissement (4) est disposée entre deux strates piézoélectriques (34) de la couche piézoélectrique (3) et est adjacente à celles-ci.

8. Composant multicouche selon l'une des revendications 1 à 7, avec lequel plusieurs strates d'affaiblissement (4) sont disposées de manière répartie sur la pile (2).

9. Composant multicouche selon l'une des revendications 1 à 8, avec lequel la strate d'affaiblissement (4) est structurée dans un plan perpendiculaire à la direction d'empilement (20) de la pile (2).

10. Composant multicouche selon la revendication 9, avec lequel la strate d'affaiblissement (4) possède des évidements (44).

11. Procédé de fabrication d'un composant multicouche piézoélectrique, comprenant les étapes suivantes :
A) mise à disposition de films de base piézoélectriques contenant un premier matériau piézoélectrique,
B) mise à disposition d'un deuxième matériau piézoélectrique qui se différencie du premier matériau piézoélectrique par son activité de frittage, les premier et deuxième matériaux piézoélectriques contenant un matériau céramique et le matériau céramique du deuxième matériau piézoélectrique se différenciant du matériau céramique du premier matériau piézoélectrique au moins par l'une des propriétés température de calcination et teneur en oxyde de plomb,
C) formation d'une pile (2) constituée des films de base piézoélectriques et d'au moins une strate contenant le deuxième matériau piézoélectrique, l'épaisseur de la strate étant choisie de telle sorte que la strate à l'état fritté est nettement plus mince qu'au moins une autre strate frittée produite à partir d'un film de base piézoélectrique,
D) frittage de la pile (2).

12. Procédé selon la revendication 11, selon lequel, à l'étape B), le deuxième matériau piézoélectrique est mis à disposition en tant que film de base et, à l'étape C), ce film de base est appliqué sur le film de base contenant le premier matériau piézoélectrique.

13. Procédé selon la revendication 11, selon lequel, à l'étape C), le deuxième matériau piézoélectrique est appliqué par sérigraphie sur l'un des films de base contenant le premier matériau piézoélectrique.
